(19) Europäisches Patentamt
European Patent Office
Office européen des brevets

(11) **EP 2 041 599 B1**

(12) **EUROPÄISCHE PATENTSCHRIFT**

(45) Veröffentlichungstag und Bekanntmachung des Hinweises auf die Patenterteilung:
**01.09.2010 Patentblatt 2010/35**

(21) Anmeldenummer: 07802374.4

(22) Anmeldetag: **10.07.2007**

(51) Int Cl.:
*G01S 7/02* (2006.01)    *G01S 7/35* (2006.01)
*G01S 7/36* (2006.01)    *G01S 13/34* (2006.01)
*G01S 13/91* (2006.01)   *H03L 7/099* (2006.01)
*H03L 7/14* (2006.01)    *H03L 7/18* (2006.01)
*G01S 13/536* (2006.01)   *G01S 13/538* (2006.01)
*G01S 13/56* (2006.01)

(86) Internationale Anmeldenummer:
**PCT/EP2007/057013**

(87) Internationale Veröffentlichungsnummer:
**WO 2008/006818 (17.01.2008 Gazette 2008/03)**

(54) **RADARANORDNUNG**

RADAR SYSTEM

SYSTÈME RADAR

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **13.07.2006 DE 102006032544**

(43) Veröffentlichungstag der Anmeldung:
**01.04.2009 Patentblatt 2009/14**

(73) Patentinhaber: **SIEMENS AKTIENGESELLSCHAFT**
**80333 München (DE)**

(72) Erfinder:
• **NALEZINSKI, Martin**
  **81541 München (DE)**
• **SEISENBERGER, Claus**
  **84181 Neufrannhofen (DE)**

(56) Entgegenhaltungen:
**EP-A- 0 599 609      EP-A- 0 816 872
EP-A- 0 945 715      EP-A1- 0 647 857
EP-A1- 0 793 348     EP-A2- 0 402 736
DE-A1- 4 030 607     JP-A- 62 210 731
US-A- 2 811 715      US-A- 4 951 005
US-A- 4 965 533      US-A- 5 075 638
US-A- 5 349 310      US-A1- 2003 020 647**

**Beschreibung**

Die Erfindung betrifft Radaranordnungen und zugeordnete Verfahren, insbesondere zur Verkehrsüberwachung

Bei der Präsenzdetektion, insbesondere in Anwendungen in der Verkehrstechnik zur Fahrzeuganwesenheits-, -abstands- und - geschwindigkeitserfassung, kommen neben optischen Systemen häufig Radarsensoren zum Einsatz. Diese Sensoren basieren üblicherweise auf einem Doppler-Radar, insbesondere in Form eines Dauerstrich ("Continuous Wave"; CW)- Radars.

Mit dem Dopplerradar kann allerdings neben der Reflexionsamplitude nur eine Änderung in der Reflexionsphase des reflektierenden Szenarios praktisch nutzbar detektiert werden. Damit kann also nur die Bewegung eine Objektes, d.h., typischerweise dessen Geschwindigkeit, gemessen werden. Verkehrssensoren nach diesem Prinzip können keine echten statischen Messungen durchführen, d.h., Szenarien, bei denen ein Messobjekt unbewegt im Detektionsbereich zu stehen kommt. In der Praxis ist es aber häufig wünschenswert, eine statische Messung durchzuführen. Das trifft beispielsweise zu, wenn die Anwesenheit eines stehenden Fahrzeugs, wie beispielsweise vor einer Ampel oder einer Parkbucht erkannt werden soll. Ebenfalls ist es in manchen Situationen wünschenswert, die Bewegung eines Fahrzeugs nur in einem vorgegebenen Abstandsbereich zu messen. Auch das ist mit einem reinen Dopplerradar nicht möglich.

Zur Durchführung von präzisen abstandsselektiven Messungen werden bisher vorwiegend empfindliche und teure optische Sensoren verwandt, die in der Regel auf bilderkennenden Konzepten basieren. Diese sind üblicherweise für einen breiten Einsatz zu teuer. Andere zur statischen Detektion einsetzbare Konzepte sind laserbasiert. Diese sind aber ebenfalls teuer und wenig robust gegenüber Umwelteinflüssen.

Die US 2003 / 020647 A1 beschäftigt sich mit der Detektion von räumlichen Unregelmäßigkeiten, wobei ein FMCW-Radar zum Einsatz kommt. Es wird ein Verfahren beschrieben, bei dem Radarsignale ("vector") aufgenommen werden. Die Vektoren (und zwar ausnahmslos sämtliche Vektoren) werden zu einem "running average vector" gemittelt mit dem Ziel, einen Hintergrund-Vektor zu ermitteln. Von einem jeweils neu aufgenommenen Vektor wird dieser Mittelwert subtrahiert, um ein Hintergrundsignal (Rauschen) zu entfernen und um so einen korrigierten Vektor zu bestimmen. In die Berechnung des Mittelwertes gehen sämtliche aufgenommenen Radarsignale ein. Auch in EP 0816872 A, die sich ebenfalls mit der Detektion von Objekten bzw. Fehlstellen mit Hilfe von FMCW-Radaren beschäftigt, werden Störsignale dadurch reduziert, dass ein Mittelwert einer Vielzahl von Einzelmessungen von der jeweiligen Einzelmessung abgezogen wird. Weiterhin ist auf die US 2811715 A hinzuweisen, in der ein ähnliches Verfahren offenbart wird.

Häufig eingesetzt werden im Verkehrsbereich Radarsensoren im Frequenzbereich von typischerweise 1 bis 100 GHz, die ausschließlich nach dem Dopplerprinzip arbeiten und daher keine statische Abstandsmessungen durchführen können. Stattdessen wird durch eine vorübergehende Phasenänderung, die entsteht, wenn sich ein Fahrzeug in den Detektionsbereich bewegt und mit einem Dopplersensor detektierbar ist, auf die Anwesenheit eines Fahrzeugs geschlossen. Unvermeidliche Driften im Messsignal, hervorgerufen beispielsweise durch Reflektivitätsänderungen des Hintergrundes oder Temperaturschwankungen, erzeugen aber ebenfalls Phasen- und Amplitudenänderungen. Diese unerwünschten Phasen- und Amplitudenänderungen können bei dieser Methode grundsätzlich nicht von Phasenänderungen durch die Anwesenheit von Objekten unterschieden werden, was eine Detektion oft unzuverlässig macht.

Durch Verwendung eines abstandsmessenden Radars, auch geläufig unter der Bezeichnung FMCW ("Frequency Modulated Continuous Wave"; frequenzmoduliertes Dauerstrich)- Radar, kann die Funktionalität bei Verkehrsanwendungen signifikant erhöht werden. Ein herkömmliches FMCW-Radar benötigt allerdings eine über der Zeit - möglichst linear - verstimmte Frequenzrampe. Derzeit werden aber in Verkehrs-Radarsensoren nach dem FMCW-Prinzip üblicherweise ungeregelte Signalquellen verwendet, die eine geringe Linearität besitzen und deren Frequenz außerdem noch eine starke Abhängigkeit (Drift) von der Temperatur besitzen. Die Nichtlinearität in der Durchstimmkennlinie vergrößert die Ortsunschärfe, mit der ein Objekt lokalisiert werden kann. Um trotz der Temperaturdrift der Mittenfrequenz stets zu gewährleisten, dass die ausgesendete Frequenz innerhalb des von den Behörden zur Verfügung stehenden Frequenzbandes bleiben, muss ein Frequenzband mit der Breite der Temperaturdrift im erlaubten Frequenzbereich als Sicherheitsband ungenutzt bleiben. Die nutzbare Durchstimmbandbreite eines ungeregelten FMCW-Radars reduziert sich dadurch merklich, und damit die Ortsauflösung des Sensors, die proportional der Durchstimmbandbreite ist. Beide Effekte reduzieren letztlich die Empfindlichkeit des Sensors. Damit besitzen ungeregelte Systeme zur Verkehrsdetektion eine geringe Empfindlichkeit. Eine Frequenzregelung direkt im GHz-Bereich wiederum ist wiederum wirtschaftlich nicht sinnvoll realisierbar.

Dieses Problem kann bspw. dadurch gelöst werden, dass bei dem FMCW-Radar, insbesondere in Form eines Fahrzeugpräsenzdetektors, ein Ausgangssignal einer durchstimmbaren Mikrowellensignalquelle von einem digital einstellbaren Frequenzteiler mit einem Teilungsverhältnis n auf eine sehr viel tiefere Frequenz geteilt wird, welche typischerweise, aber nicht zwingend, im Bereich von 1 bis 100 MHz liegt. Dieses Signal wird einer Phasenregelschleife zugeführt. Dort wird das Signal bei dieser Frequenz mit einen Referenzsignal einer hochgenauen Referenz-Signalquelle verglichen, beispielsweise eines Quarzoszillators. Über ein Schleifenfilter steuert die Phasenregelschleife dann die Frequenz des Mikrowellenoszillators.

In einer weiteren Ausführung kann ein, insbesondere digital, gesteuerter Frequenzteiler mit dem Teilungsverhältnis m zwischen die Referenz-Signalquelle und die Phasenregelschleife geschaltet werden, wobei n dann nicht mehr digital steuerbar sein muss, aber sein kann. Der Frequenzteiler mit dem Teilungsverhältnis n dient dazu, die Frequenz des Ausgangssignals des durchstimmbaren Oszillators in einen Frequenzbereich zu teilen, bei dem die Phasenregelschleife funktioniert. In diesem Fall wird also das um das Teilerverhältnis n geteilte Mikrowellensignal mit der um m geteilten Referenzfrequenz verglichen. Diese liegt typischerweise, aber nicht zwingend bei 1 KHz bis 100 MHz. Eine Frequenzrampe wird durch kontinuierliches Verändern des sehr exakt einstellbaren Teilungsverhältnis n des Teilers linear durchgestimmt. Der digital steuerbare Teiler kann in beiden Ausführungsformen beispielsweise entweder als ganzahliger, als gebrochen rationaler Teiler oder als DDS-Struktur ausgeführt sein.

Durch die Verwendung eines solchen FMCW-Radars, insbesondere als Verkehrsdetektor, mit digital kontrollierter Rampe ergibt sich der Vorteil, dass der zur Verfügung stehende Frequenzbereich optimal genutzt wird, da keine unkontrollierte Frequenzdrift der durchstimmbaren Mikrowellensignalquelle über der Temperatur mehr auftritt und somit kein Sicherheits-Frequenzband an den Bandgrenzen ungenutzt bleiben muss. Das Durchstimmen mit einer hochlinearen Rampe erhöht die Auflösung des Sensors. Der Verkehrsdetektor besitzt durch beide Maßnahmen eine höhere Empfindlichkeit, als ein herkömmlicher Verkehrsdetektor. Durch die Arbeitsfrequenz im Mikrowellenbereich ist der vorgeschlagen Verkehrsdetektor außerdem sehr robust gegenüber Umwelteinflüssen. Damit lassen sich in der Verkehrsüberwachung deutlich verbesserte Erkennungsraten erzielen.

Darüber hinaus ist der Verkehrsdetektor auch leichter fertigbar ist als herkömmliche Radarsensoren, da bei der Fertigung eine funkzulassungskonforme Sendefrequenz ohne mechanische Abstimmmaßnahmen herzustellen ist. Dadurch besitzt der Sensor einen Kostenvorteil gegenüber herkömmlichen FMCW-Sensoren.

Ebenfalls vorteilhaft ist die Möglichkeit, aufgrund des FMCW-Prinzips die Bewegungsdetektion auf einen bestimmten Entfernungsbereich zu begrenzen, z. B. durch elektronische Einstellung eines Torbereichs. Damit ist es z. B. möglich, Fußgänger auf einem Fußgängerüberweg zu detektieren und gleichzeitig die Detektion von entfernteren bewegten Objekten, z. B. Autos, zu vermeiden. Zudem erlaubt dies eine größere Freiheit bei der Wahl des Montageortes.

Dabei können die folgenden Fälle auftreten:

- Die Dopplerfrequenz ist sehr viel kleiner als die Abstandsfrequenz. Dann löst ein bewegtes Objekt, welches sich außerhalb des festgelegten Detektionsbereichs befindet und im Zeitsignal einen hohe Signalamplitude besitzt, dennoch keine Detektion aus. Dies gilt sowohl bei einer aufsteigenden als auch bei einer abfallenden Frequenzrampe.

- Die Dopplerfrequenz ist vergleichbar oder größer als die Abstandsfrequenz. In diesem Fall erscheint die Objektfrequenz bei der Abwärtsrampe im Detektionsbereich, nicht jedoch bei der Aufwärtsrampe. Werden die beiden Spektren dem gleichen Objekt zugeordnet, kann die Abstandsfrequenz ohne den Doppleranteil als arithmetisches Mittel aus beiden Frequenzen ausgerechnet werden. Vereinfacht gesagt, lässt das Springen der Spektrallinie bereits erkennen, dass das beobachtete Objekt nicht statisch ist. Wenn der arithmetische Mittelwert der Frequenz der springenden Linie im Detektionsbereich bis zur nächsten springenden Linie außerhalb des Detektionsbereichs ebenfalls außerhalb des Detektionsbereichs liegt, befindet sich auch kein bewegtes Objekt im Detektionsbereich.

- Umgekehrt ist die Dopplerfrequenz eines bewegten Objekts um dessen Abstandsfrequenz verschoben. Bei einem herkömmlichen Dopplersensor erzeugen langsam bewegte Messobjekte niederfrequente Dopplerfrequenzen. Diese werden von der in der Regel vorhandenen DC-Entkopplung im Messsignalzweig gedämpft oder völlig unterdrückt. Bei der Bewegungsdetektion mit dem erfindungsgemäßen FMCW-Radar bzw. Verkehrssensor ist die Dopplerfrequenz des Messobjekts um dessen Abstandsfrequenz verschoben. Es ist jetzt in Frequenz höher und kann dadurch die DC-Entkopplung passieren. Dadurch ist das erfindungsgemäße Radar sehr viel empfindlicher als ein reines Festfrequenz-Dopplerradar.

Der erfindungsgemäße Radarsensor weist ferner den Vorteil auf, dass mit einem frequenzgeregelten FMCW-Radar neben der echten Abstandsmessung außerdem noch eine Bewegungsdetektion parallel durchgeführt werden kann. Die Abstandsmesssignale sind von Messzyklus (= einmaliges Durchstimmen der Frequenzrampe) zu Messzyklus kohärent zueinander, die Dopplersignale hingegen nicht. Damit wird es möglich, parallel zur Abstandsmessung die hochempfindliche Bewegungsdetektion durchzuführen. Die hohe Empfindlichkeit der Bewegungsdetektion resultiert aus dem hohen Phasenhub durch eine Bewegung. Während sich das Abstandssignal erst bei einer Ortsänderung des Messobjektes in der Größenordnung von

$$d = 0.5 \bullet c/\Delta f$$

deutlich verändert, verändert sich das Dopplersignal bereits durch Ortsänderungen im Bereich der Wellenlänge der Sensor-Mittenfrequenz $f_0$ gemäß:

$$d = 0.5 \bullet c/f_0.$$

Bei typischen Bandbreiten im Bereich von 100 MHz und einer Mittenfrequenz von typischerweise 24 GHz, findet in ersterem Fall eine deutliche Veränderung des Messsignals bei Bewegungen im Bereich von 1.5 m statt, während sich die deutliche Veränderung des Dopplersignals bereits bei einer Bewegung von 6 mm ergibt.

Erzeugt ein einzelnes bewegtes Messobjekt ein Dopplersignal weitgehend konstanter Frequenz, dann ist diese Dopplerfrequenz deutlich im Spektrum des Einzelsignals zu erkennen. Bei Mittelung mehrerer Betragsspektren bleibt diese Dopplerspektrallinie bestehen. Die Dopplerlinie ist dabei grundsätzlich nicht von einer Abstandslinie eines statischen Objektes zu unterscheiden. Bei einer komplexwertigen, also phasenrichtigen Mittelung aufeinanderfolgender Messsignale findet dagegen eine Unterdrückung der Dopplerkomponente statt, da diese im Gegensatz zur Abstandskomponente von Messzyklus zu Messzyklus nicht kohärent ist. Im Spektrum der komplexwertig gemittelten Messsignale verschwinden somit alle Dopplersignalanteile. Somit wird das Dopplersignal von Abstandsignalen unterscheidbar. Eine gleichzeitige, hochempfindliche Detektion, getrennt nach statischen und bewegten Objekten, ist möglich.

Wie bereits ausgeführt, kommen bei der Präsenzdetektion, insbesondere in Anwendungen in der Verkehrstechnik zur Fahrzeuganwesenheits-, -abstands- und -geschwindigkeitserfassung, neben optischen Systemen häufig Radarsensoren zum Einsatz. Diese Sensoren sind häufig aus Kostengründen Doppler-Radare, d. h., sogenannten Dauerstrich (CW-) Radare. Diese detektieren prinzipiell nur Änderungen der Reflexionsphase, also Änderungen des reflektierenden Szenarios, und liefern evtl. noch einen einzelnen Phasenwert, welcher der gewichteten Phase aller zur Reflexion beitragenden Objekte entspricht.

In zunehmendem Maß kommt auch ein echtes FMCW-Radar für Verkehrsanwendungen zum Einsatz. Mit diesem kann der Abstand zu einem Objekt gemessen werden. Es ist somit prinzipiell dazu geeignet, statische Messungen durchzuführen, d. h., die Anwesenheit statischer Objekte über eine Abstandsmessung zu detektieren. In der Realität ergibt sich das Problem, dass auch der Unter-/Hintergrund ein statisches Objekt ist, welches häufig nicht von dem eigentlichen Messobjekt getrennt detektiert werden kann. Bei einem FMCW-Radar ist nämlich die Fähigkeit, zwei statische Objekte getrennt von einander aufzulösen, durch die verfügbare Durchstimmbandbreite bestimmt.

Aus Gründen der Funkzulassung ist die Durchstimmbandbreite B in der Regel aber nennenswert beschränkt, d. h., dass bei kleinem Abstand zwischen einem Messobjekt und dem Hintergrund (z. B. Untergrund) beide Reflexionen nicht mehr als getrennte Reflexionen zu unterscheiden sind. Klein bedeutet in diesem Zusammenhang, dass der Abstand D zwischen dem Objekt und dem Hintergrund in der Größenordnung oder kleiner als

$$D = c/B$$

ist, wobei c die Lichtgeschwindigkeit ist.

Bei kleiner Bandbreite kann also keine zuverlässige statische Messung durchgeführt werden, weil die Reflexion eines Messobjekts und des Hintergrundes nicht getrennt erkannte werden können. Der Abstandswert, der aus Gesamtmesssignal mit und ohne Objekt gewonnen wird, unterscheidet sich nicht deterministisch von dem Messsignal, das nur die Hintergrundreflexion, das sogenannte Leersignal, aufweist. Dies bedeutet, dass dann, wenn beide Reflexionen nicht getrennt aufgelöst werden können, der ermittelte Abstandswert mit Objekt gegenüber nur dem Leersignal anwachsen oder schrumpfen kann.

Zur Detektion eines statischen Messobjektes mit einem schmalbandigen Radar wird bisher eine Änderung des statischen Messsignals herangezogen. Ist der zu gegebenen Hintergrundreflexionen gehörende Messsignalanteil bekannt, und wird vom gesamten Messsignal abgezogen, bleibt nur der zu einem ggf. anwesenden Messobjekt gehörende Signalanteil übrig. Überschreitet das Differenzsignal einen vorgegebenen Schwellwert, wird ein Objekt detektiert.

Physikalisch ist es aus Prinzip nicht möglich, das Signal eines beliebigen Objektes und ein beliebiges Leersignal ohne weitere Maßnahmen voneinander zu unterscheiden. Daher kann der Hintergrundanteil im Messsignal nur gewonnen werden, indem der Detektionsbereich zunächst ohne Messobjekt gemessen wird und dieses Signal im Weiteren von allen Messsignalen abgezogen wird. Diese Methode funktioniert aber nur über eine kurze Zeitdauer gut, da nach einer gewissen Zeit Driften im Radarsensor oder dem Hintergrund das Hintergrundsignal verändern. Driften treten typischerweise langsam auf und sind beispielsweise auf Änderungen in der Reflektivität des Untergrundes durch aufkommenden Regen oder Verschmutzung etc. zurückzuführen. Innerhalb des Sensors treten Driften der Signalphase, der Sendefrequenz oder Signalamplituden z.B. durch Temperaturänderungen auf. Somit stimmt das abgespeicherte Leersignal nicht mehr mit dem aktuellen überein, und eine wirksame Subtraktion ist nicht mehr möglich. Folglich ist das Leersignal während der laufenden Messungen kontinuierlich an solche Veränderungen des Hintergrundes anzupassen. Dabei ist sicherzustellen, dass das Leersignal nur an Änderungen angepasst wird, die tatsächlich durch Driften entstehen und nicht an solche, die durch Auftreten eines Objektechos entstehen.

Es ist daher eine Aufgabe der vorliegenden Erfindung, Abstandsmessungen statischer Objekte auch bei driftendem Hintergrundsignal verlässlich durchführen zu können, insbesondere auch mittels eines CW-Radars oder eines schmalbandigen FMCW-Radars.

Diese Aufgabe wird durch Verfahren nach Anspruch 1 und / oder 2 gelöst. Vorteilhafte Ausgestaltungen sind insbesondere dem Unteranspruch entnehmbar.

Die Methode beruht auf dem Ermitteln des Unterschiedes zwischen dem aktuellen Messsignal und einem adaptiv nachgeführten Leersignal. Dabei wird das unerwünschte Hintergrundsignal während der Messungen adaptiv an Driften des Sensors oder des Hintergrundes angepasst, wobei Änderungen des Hintergrunds durch Messobjekte erkannt werden. Bei dieser Methode sollte sich die Reflexion des Hintergrundes nur "langsam", also nicht plötzlich ändern und / oder sich auf eine Weise ändern, die sich in der Charakteristik von Änderungen durch Messobjekte unterscheidet.

Eine Voraussetzung dafür, dass ein Messsignal gut als Leersignal verwendbar ist, besteht darin, dass zum Erfassungszeitpunkt keine Bewegung im Detektionsbereich stattfindet, d.h., dass kein Dopplersignal vorhanden ist. Solange sich Objekte in oder durch den Überwachungsbereich bewegen, erzeugen sie dabei im Gegensatz zum statischen Hintergrund ein merkliches Dopplersignal. Die Anwesenheit eines Messobjektes ist offensichtlich; bei der Detektion von Fußgängern wird beispielsweise in der Regel während deren gesamter Aufenthaltsdauer im Radarstrahl ein Dopplersignal erzeugt. Ein realer Hintergrund ist dagegen weitgehend statisch, d. h., dass das Hintergrundsignal praktisch kein Dopplersignal enthält. Solange also der Dopplersignalanteil oberhalb einer vorgegebenen Werte- bzw. Signalschwelle liegt, bewegen sich Objekte im Detektionsbereich.

Die Detektion des Doppleranteils kann über mehrere Verfahren erfolgen, z. B. über die Analyse eines Zeitsignals und / oder eines Signalspektrums. Einem bewegten Objekt entspricht im Zeitsignal eine hohe Signalamplitude, im Frequenzbereich eine Spektrallinie bzw. ein Frequenzband, welches deutlich aus dem Rauschen ragt. Ein besonders vorteilhaftes Verfahren, einen Doppleranteil zu erkennen, besteht darin, zwei aufeinanderfolgende Messungen miteinander zu vergleichen. Unterscheiden sich diese um mehr als einen vorgegebenen Schwellwert, ist ein Dopplersignal vorhanden.

Ist kein Dopplersignal vorhanden, kann das Hintergrundsignal adaptiv nachgeführt werden. Dazu wird das Hintergrundsignal in regelmäßigen Zeitintervallen gemessen. Diese mutmaßlichen Leersignale werden in einer Tabelle nacheinander abgelegt. Die Länge des Zeitintervalls $\Delta\tau$ zwischen zwei Messungen wird an die typische Geschwindigkeit angepasst, mit der sich das Leersignal ändert. Typische Zeiten für Verkehrsanwendungen liegen im Bereich einiger Sekunden bis einige 10 Sekunden. Ein mutmaßliches Hintergrundsignal wird nur dann gespeichert, wenn kein signifikantes Dopplersignal im Messsignal ermittelt wird. Das Leersignal kann als Zeitsignal oder als Spektrum abgelegt werden. Ebenso gut können aber auch nur einzelne Merkmale in der Tabelle abgelegt und mit dem entsprechenden Merkmal des aktuellen Messsignals verglichen werden. Merkmale können z. B. die Frequenz des Maximums im Spektrum oder die Amplitude des Maximums umfassen.

Das Nachführen des Hintergrundes erfolgt z. B. dadurch, dass die Tabelle nach dem wahrscheinlichsten Hintergrundsignal durchsucht wird, z. B. nach demjenigen Signalverlauf, der mit geringer Abweichung am häufigsten in der Tabelle abgelegt ist. Mit diesem wird das aktuelle Messsignal verglichen. Unterschreitet der Unterschied einen vorbestimmten Schwellwert, wird das aktuelle Messsignal als Leersignal identifiziert. Durch Übereinstimmung des aktuellen Messsignals mit einer Vielzahl von zuvor gespeicherten mutmaßlichen Leersignalen aus der Tabelle kann mit höherer Sicherheit das aktuelle Signal als Leersignal erkannt werden. Zum Vergleichen können ggf. mehrere Messsignale und oder auch mehrere Leersignale gemittelt werden um Unterschiede durch Rauschen und Clutter zu kompensieren. Die Länge der Tabelle, und damit der überprüfbare Zeitraum, in dem Messungen aufgezeichnet wurden, kann dazu benutzt werden, die Haltezeit für die statische Detektion einzustellen. Diese liegt bei Verkehrsanwendungen typischerweise zwischen wenigen Minuten bis zu einigen 10 Minuten.

Eine Änderung der gemessenen Reflexion, die "schnell" oder plötzlich auftritt, führt auch dann zu einer Objektdetektion, wenn die Veränderung anschließend statisch anhält. Damit ist eine statische Messung möglich. Kehrt das Messsignal innerhalb einer vorgegebenen Zeitspanne wieder zu einem Signal zurück, das dem wahrscheinlichsten Leersignal ähnlich ist, wird die Detektion aufgehoben. Bleibt die Änderung dagegen über diese Zeitspanne erhalten, wird dieses statische Signal als neues Hintergrundsignal angenommen. Rührte die Änderung von einem Messobjekt her, welches sich länger als die Haltezeit im Detektionsbereich aufhielt, wird es nicht mehr detektiert. Bewegt es sich danach wieder aus dem Detektionsbereich, wird eine Veränderung gegenüber dem falschen Leersignal detektiert und damit fälschlicherweise die Anwesenheit eines Messobjektes festgestellt. Die Falschdetektion hält solange an, bis das Leersignal durch erneute Überschreitung der Haltezeit neu eingestellt wurde. Unter diesem Aspekt ist eine kurze Zeitkonstante wünschenswert, damit eine Fehldetektion schnell korrigiert wird. Um verschiedenen Messsituationen gerecht zu werden, kann die Zeitkonstante adaptiv der Situation angepasst werden. Ebenfalls können ineinander geschachtelte Tabellen mit unterschiedlichen Haltezeiten verwendet werden, um z. B. schnellere Reflexionsänderungen vorzubewerten und ein nach dieser Vorbewertung ermitteltes Leersignal einer Tabelle für langsame Hintergrundänderungen zuzuführen.

Die Wahl der Länge dieser Zeitspanne bestimmt also, wie langsam eine Reflexionsänderung durch ein Objekt stattfinden darf, bevor diese als Hintergrundänderung erkannt wird, Durch Einstellung der Haltezeit kann das Verfahren optimal an die Messaufgabe angepasst werden. (z.B. kann eine kürzere Haltezeit für die Detektion von Fußgängern eingestellt werden und eine längere Haltezeit für die Detektion von Fahrzeugen)

Kleine, sich stetig zwischen aufeinanderfolgenden Messungen fortentwickelnde Änderungen werden ebenfalls als Änderung des Hintergrunds erkannt. Durch die Verwendung einer möglichst langen Tabelle, können Vergleiche zu vielen Leersignalen durchgeführt werden, was eine hohe Plausibilitätsprüfung zulässt. Ein Leersignal kann während der gesamten Haltezeit konstant gehalten werden und in dem Moment, in dem es als ungültig bewertet wird, schlagartig durch ein neues Leersignal ausgetauscht werden.

Ebenso können beim FMCW-Radar verschiedene Haltezeiten für verschiedene Entfernungs-/Frequenzbereiche des Messsignals gewählt werden, um beispielsweise Driften im Sensor (sehr niedrige Messsignalfrequenz) anders zu bewerten als Objekt-/Leersignale (höhere Messsignalfrequenz).

Bei der beschriebenen Methode der adaptiven Hintergrundnachführung können weitere Merkmale der Hintergrund und Objektreflexion, sofern vorhanden, genutzt werden um statische Messobjekte vom Hintergrundsignal zu unterscheiden. Beispielsweise kann der Übergang von einem statischen Zustand in den Anderen (z.B. durch typische Dopplersignaturen) darauf schließen lassen, ob eine Signaländerung durch eine "schnelle" Hintergrundänderung oder eine "langsame" Objektänderung stattfand.

Eine andere Methode, das Leersignal nachzuführen, besteht darin, aufeinanderfolgende Signale gleitend oder blockweise zu mitteln. Hierbei kommen übliche Mittelungsverfahren in Frage. Beim Mitteln fließen auch "Ausreißer", d. h., gelegentliche Fehlmessungen, in die Bildung des Leersignals ein. Außerdem verändert sich das gültige Leersignal allmählich. Damit verändert ein statisches Objekt, welches sich längere Zeit im Detektionsbereich befand, das aktuelle Leersignal. Eine Mittelung ist folglich nur für kurze Haltezeiten sinnvoll.

Mit dem beschriebenen Detektionsverfahren können auch mit einem schmalbandigen FMCW- oder Dopplerradar sowohl statische als auch bewegte Objekte erkannt werden. In beiden Fällen weicht das aktuelle Messsignal von dem gespeicherten Leersignal ab. Das Verfahren benötigt keine Kalibrierung bei der Installation. Nach dem Einschalten des Sensors wird das Hintergrundsignal allmählich nach oben beschriebenem Ablauf gebildet. Werden die Leersignale in einem nichtflüchtigen Speicher abgelegt, kann eine statische Detektion direkt nach dem Einschalten wieder erfolgen. Kurz bedeutet in diesem Zusammenhang, dass die Zeit kürzer ist als eine signifikante Änderung der Hintergrundreflexion.

Beim Einsatz mehrerer FMCW-Radarsysteme besteht in der Praxis das Problem, dass in Fällen, in denen mehrere Systeme im Einsatz sind, sich diese gegenseitig anstrahlen und "blenden" können. Dieser Fall tritt insbesondere dann ein, wenn der Frequenzbereich, in dem die Sensoren senden dürfen, sehr eng ist, und jeder Sensor die maximal verfügbare Bandbreite nutzt.

Im Normalfall sendet der einzelne Sensor regelmäßige Frequenzrampen (mit einer Bandbreite von typischerweise 0,1 GHz bis 1 GHz) aus, empfängt dieses von Zielen reflektierte Signal und mischt es mit dem augenblicklichen Sendesignal. In dem dabei entstehenden und üblicherweise sehr niederfrequenten Zwischenfrequenz (ZF)- bzw. Differenzfrequenzsignal (Frequenz typischerweise von 0.01 KHz bis 1000 KHz) steckt die gewünschte Entfernungs- und Geschwindigkeitsinformation zu dem angestrahlten Ziel. Eine einzelne Messung entspricht dabei dem Senden und Empfangen einer einzelnen Rampe. Beim Vorhandensein mehrerer FMCW-Radarsensoren empfängt der einzelne Sensor nicht nur die Reflexion des eigenen Sendesignals sondern auch die gesendeten Frequenzrampen der anderen Sensoren direkt oder über Reflexionen. Insbesondere, wenn ein Sensor auf kurzem Wege und damit mit hoher Leistung in einen zweiten Sensor hineinstrahlt, wird dieses Empfangssignal im zweiten Sensor mit dessen augenblicklichen Sendesignal zu einem ZF-Signal mit sehr hoher Amplitude gemischt. Die meiste Zeit während der Frequenzrampe liegen die Frequenzen der zwei Signale um deutlich mehr als 1 MHz auseinander. Das ZF-Signal liegt also in der Frequenz folglich deutlich über der ZF-Bandbreite und wird durch Filterung unterdrückt. Lediglich zu Zeitpunkten, an denen sich zwei Frequenzrampen kreuzen bzw. schneiden, entsteht als Differenzfrequenzsignal ein Signal, welches spektral im Bereich des eigentlichen Nutzsignals liegt. Dieses Signal ist dem eigentlichen Nutzsignal überlagert und macht dieses während eines kurzen Zeitabschnitts einer Messung zur Auswertung unbrauchbar. Diese Problematik kann z. B. bei Systemen zur Verkehrssteuerung auftreten. Dabei können an Kreuzungen oder Fußgängerüberwegen mehrere Radarsensoren montiert sein, um gezielt mehrere Bereiche des Verkehrsraumes zu überwachen.

Die Erfindung wird in den folgenden Figuren anhand von Ausführungsbeispielen schematisch genauer ausgeführt.

FIG 1     zeigt in Schrägansicht eine Skizze einer FMCW- Radaranordnung zur Stoplinien-Detektion;

FIG 2     zeigt eine Schaltungsskizze einer hochpräzisen Sig- nalerzeugungseinheit eines FMCW-Radars, z. B. aus FIG 1; und

FIG 3     zeigt eine Schaltungsskizze einer weiteren hochprä- zisen Signalerzeugungseinheit eines FMCW-Radars, z. B. aus FIG 1;

FIG 4A-4C     zeigen eine Auftragung eines Signals in beliebigen Einheiten gegen eine Frequenz, nämlich in FIG 4(a) einen gemeinsamen Signalverlauf eines Hintergrundsignals und eines Signals eines sich bewegenden Ob- jekts, in FIG 4(b) einen Signalverlauf nur des Hin- tergrundsignals und in FIG 4C einen Signalverlauf nur des Objektsignals;

FIG 5A-5C zeigen mutmaßliche Hintergrunds- bzw. Leersignale, die zur adaptiven Nachführung eines Hintergrundsig- nals, z. B. des FMCW-Radars aus FIG 1, in einer Ta- belle abgelegt sind;

FIG 6 zeigt in einer Auftragung einer Frequenz gegen eine Zeit zwei Rampen sich störender FMCW-Radare mit un- terschiedlicher Rampenform;

FIG 7 zeigt in einer Auftragung einer Amplitude gegen ei- ne Zeit das sich bei einem der sich störenden FMCW- Radare von FIG 6 ergebende Sensorsignal;

FIG 8 zeigt in einer Auftragung einer Frequenz gegen eine Zeit zwei Rampen sich störender FMCW-Radare mit gleicher, aber versetzter Rampenform;

FIG 9 zeigt in einer Auftragung einer Amplitude gegen ei- ne Zeit das sich bei einem der sich störenden FMCW- Radare von FIG 8 ergebende Sensorsignal;

FIG 10 zeigt in einer Auftragung einer Amplitude gegen ei- ne Zeit eine Ausblendung einer Überkreuzung von Rampen aus FIG 8 mit Wichtungsfunktion.

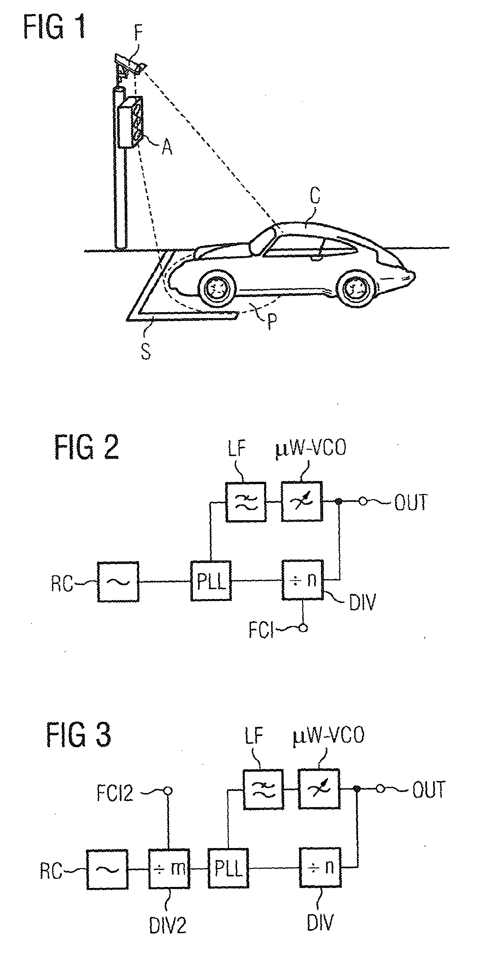

FIG 1 zeigt FMCW-Radaranordnung zur Stoplinien-Detektion mit einem FMCW-Radar F, das oberhalb einer Ampel A montiert ist und einen Ausleuchtbereich P auf einer Fahrbahn aufweist, welche eine Stoplinie S aufweist. Durch das FMCW-Radar F kann die Anwesenheit eines stehenden Fahrzeugs C an der Stoplinie S detektiert werden.
FIG 2 zeigt eine Schaltungsskizze einer hochpräzisen Signalerzeugungseinheit des FMCW-Radars für die Rampensteuerung mit einem Teiler DIV mit Teilerverhältnis n (ganzzahlig oder gebrochen rational) im Mikrowellensignal.
Das Ausgangssignal OUT der durchstimmbaren Mikrowellensignalquelle μW-VCO wird von einem digital einstellbaren Frequenzteiler DIV mit dem Teilungsverhältnis n auf eine sehr viel tiefere Frequenz geteilt, welche typischerweise, aber nicht zwingend, im Bereich von 1 bis 100 MHz liegt. Dieses frequenzgeteilte Signal wird einer Phasenregelschleife PLL zugeführt. Dort wird das Signal mit dem Referenzsignal bei eben dieser Frequenz verglichen, welches von einem Quarzoszillator als einer hochgenauen Signalquelle RC, entstammt. Über ein Schleifenfilter LF steuert die PLL die Frequenz des Mikrowellenoszillators μW-VCO. In anderen Worten wird somit die Mikrowellensignalquelle μW-VCO mittels einer Regelschleife eingestellt, die als Führungsgröße ein hochgenaues Referenzsignal verwendet. Das Teilungsverhältnis n ist mittels eines Teilersteuereingangs FCI digital einstellbar.
FIG 3 zeigt eine Schaltungsskizze einer hochpräzisen Signalerzeugungseinheit des FMCW-Radars für die Rampensteuerung mit im Vergleich zu FIG 2 einem zusätzlichen Teiler DIV2 mit Teilerverhältnis m (ganzzahlig oder gebrochen rational) im Referenzsignalgang zwischen der Referenzquelle RC und der Phasenregelschleife PLL. Das Teilerverhältnis m des zusätzlichen Teilers DIV2 ist mittels eines zugeordneten Teilersteuereingangs FCI2 digital einstellbar.
Dabei ist der Frequenzteiler DIV2 (digital) gesteuert, so dass dann das Teilungsverhältnis n des Teiler DIV nicht mehr (digital) steuerbar sein muss, aber sein kann. Der Teiler DIV mit dem Teilungsverhältnis n dient dazu, die Frequenz des Ausgangssignals OUT des VCO in einen Frequenzbereich zu teilen, bei dem die Phasenregelschleife PLL funktioniert. In diesem Fall wird also das um das Teilerverhältnis n geteilte Mikrowellensignal OUT mit der um m geteilten Referenzfrequenz der Referenzsignalquelle RC verglichen. Diese liegt typischerweise, aber nicht zwingend, zwischen 1 KHz und 100 MHz. Eine Frequenzrampe wird durch kontinuierliches Verändern des sehr exakt einstellbaren Teilungsverhältnisses des zweiten Teilers DIV2 linear durchgestimmt.
Die digital steuerbaren Teiler DIV, DIV2 können in den FIG 2 oder 3 entweder als ganzahliger oder gebrochen rationaler Teiler, oder als DDS-Struktur ausgeführt sein.

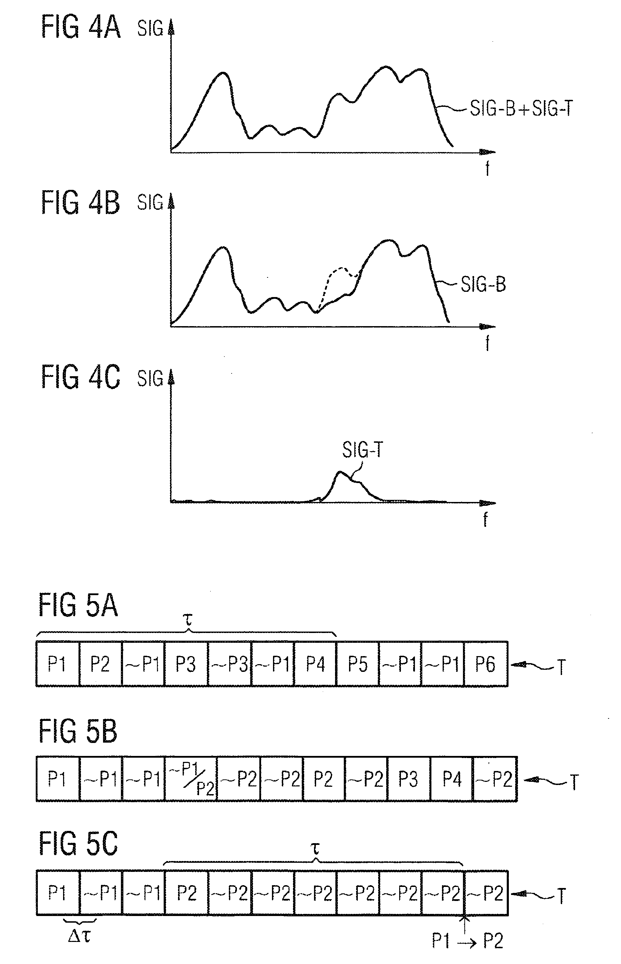

FIG 4 zeigt in drei Teilbildern eine Auftragung eines Radarsignals SIG in beliebigen Einheiten gegen eine zugehörige Frequenz f, nämlich in FIG 4(a) einen gemeinsamen Signalverlauf eines Hintergrundsignals SIG-B und eines Signals eines sich bewegenden Objekts SIG-T, in FIG 4(b) einen Signalverlauf nur des Hintergrundsignals SIG-B und in FIG 4C einen Signalverlauf nur des Objektsignals SIG-T.
FIGN 5A-5C zeigt mutmaßliche Hintergrunds- bzw. Leersignale P, die zur adaptiven Nachführung eines Hintergrundsignals, z. B. des FMCW-Radars aus FIG 1, in einer Tabelle T abgelegt sind.
Ist kein Dopplersignal vorhanden, kann das Hintergrundsignal SIG-B aus FIG 4 adaptiv nachgeführt werden. Dazu wird das Hintergrundsignal SIG-B aus FIG 4 in regelmäßigen Zeitintervallen Δτ gemessen. Diese mutmaßlichen Leersignale (P1, P2,...) werden, wie in FIG 5A dargestellt, in einer Tabelle T nacheinander abgelegt. Die Länge eines Zeitintervalls Δτ zwischen zwei Messungen Pn, Pn+1 (n ≥ 1) wird an die typische Geschwindigkeit angepasst, mit der sich das Leersignal Pn ändert. Typische Zeiten für Verkehrsanwendungen liegen im Bereich einiger Sekunden bis einige 10 Sekunden. Ein mutmaßliches Hintergrundsignal Pn wird nur dann gespeichert, wenn kein signifikantes Dopplersignal im Messsignal ermittelt wird. Das Leersignal Pn kann als Zeitsignal oder als Spektrum abgelegt werden. Ebenso gut können aber auch nur einzelne Merkmale in der Tabelle abgelegt und mit dem entsprechenden Merkmal des aktuellen Messsignals verglichen werden. Merkmale können z. B. die Frequenz des Maximums im Spektrum oder die Amplitude des Maximums umfassen.

Das Nachführen des Hintergrundes erfolgt z. B. dadurch, dass die Tabelle nach dem wahrscheinlichsten Hintergrundsignal durchsucht wird, z. B. nach demjenigen Signalverlauf, der mit geringer Abweichung am häufigsten in der Tabelle abgelegt ist, wie ebenfalls in FIG 5A dargestellt. Mit diesem wird das aktuelle Messsignal verglichen. Unterschreitet der Unterschied einen vorbestimmten Schwellwert, wird das aktuelle Messsignal als Leersignal identifiziert. Durch Übereinstimmung des aktuellen Messsignals mit einer Vielzahl von zuvor gespeicherten mutmaßlichen Leersignalen P1 - P6 aus der Tabelle kann mit höherer Sicherheit das aktuelle Signal als Leersignal erkannt werden. Zum Vergleich können ggf. mehrere Messsignale und oder auch mehrere Leersignale gemittelt werden, um Unterschiede durch Rauschen und Clutter zu kompensieren. Die Länge der Tabelle, und damit der überprüfbare Zeitraum, in dem Messungen aufgezeichnet wurden, kann dazu benutzt werden, die Haltezeit $\tau$ für die statische Detektion einzustellen. Diese liegt bei Verkehrsanwendungen typischerweise zwischen wenigen Minuten bis zu einigen 10 Minuten.

Eine Änderung der gemessenen Reflexion, die "schnell" oder plötzlich auftritt, führt auch dann zu einer Objektdetektion, wenn die Veränderung anschließend statisch anhält. Damit ist eine statische Messung möglich. Kehrt das Messsignal innerhalb einer vorgegebenen Zeitspanne wieder zu einem Signal zurück, das dem wahrscheinlichsten Leersignal ähnlich ist, wird die Detektion aufgehoben. Bleibt die Änderung dagegen über diese Zeitspanne erhalten, wird dieses statische Signal, wie in Fig. FIG 5C symbolisch dargestellt als neues Hintergrundsignal angenommen. Rührte die Änderung von einem Messobjekt her, welches sich länger als die Haltezeit im Detektionsbereich aufhielt, wird es nicht mehr detektiert. Bewegt es sich danach wieder aus dem Detektionsbereich, wird eine Veränderung gegenüber dem falschen Leersignal detektiert und damit fälschlicherweise die Anwesenheit eines Messobjektes festgestellt. Die Falschdetektion hält solange an, bis das Leersignal durch erneute Überschreitung der Haltezeit neu eingestellt wurde. Unter diesem Aspekt ist eine kurze Zeitkonstante wünschenswert, damit eine Fehldetektion schnell korrigiert wird. Um verschiedenen Messsituationen gerecht zu werden, kann die Zeitkonstante adaptiv der Situation angepasst werden. Ebenfalls können ineinander geschachtelte Tabellen mit unterschiedlichen Haltezeiten verwendet werden, um z. B. schnellere Reflexionsänderungen vorzubewerten und ein nach dieser Vorbewertung ermitteltes Leersignal einer Tabelle für langsame Hintergrundänderungen zuzuführen.

Die Wahl der Länge dieser Zeitspanne bestimmt also, wie langsam eine Reflexionsänderung durch ein Objekt stattfinden darf, bevor diese als Hintergrundänderung erkannt wird, Durch Einstellung der Haltezeit kann das Verfahren optimal an die Messaufgabe angepasst werden. (z. B. kann eine kürzere Haltezeit für die Detektion von Fußgängern eingestellt werden und eine längere Haltezeit für die Detektion von Fahrzeugen) Kleine, sich stetig zwischen aufeinanderfolgenden Messungen fortentwickelnde Änderungen, wie sie einer Abfolge wie in FIG 5B entsprechen, werden ebenfalls als Änderung des Hintergrunds erkannt. Durch die Verwendung einer möglichst langen Tabelle, können Vergleiche zu vielen Leersignalen Pn durchgeführt werden, was eine hohe Plausibilitätsprüfung zulässt. Ein Leersignal Pn kann während der gesamten Haltezeit konstant gehalten werden und in dem Moment, in es als ungültig bewertet wird, schlagartig durch ein neues Leersignal Pn ausgetauscht werden. Ebenso können beim FMCW-Radar verschiedene Haltezeiten für verschiedene Entfernungs-/ Frequenzbereiche des Messsignals gewählt werden, um beispielsweise Driften im Sensor (sehr niedrige Messsignalfrequenz) anders zu bewerten als Objekt-/Leersignale (höhere Messsignalfrequenz).

Dadurch wird eine Synchronisation der Frequenzrampen möglich, ohne dass die Sensoren über einen zusätzlichen Kommunikationskanal verfügen, noch zusätzliche Hardware notwenig ist.

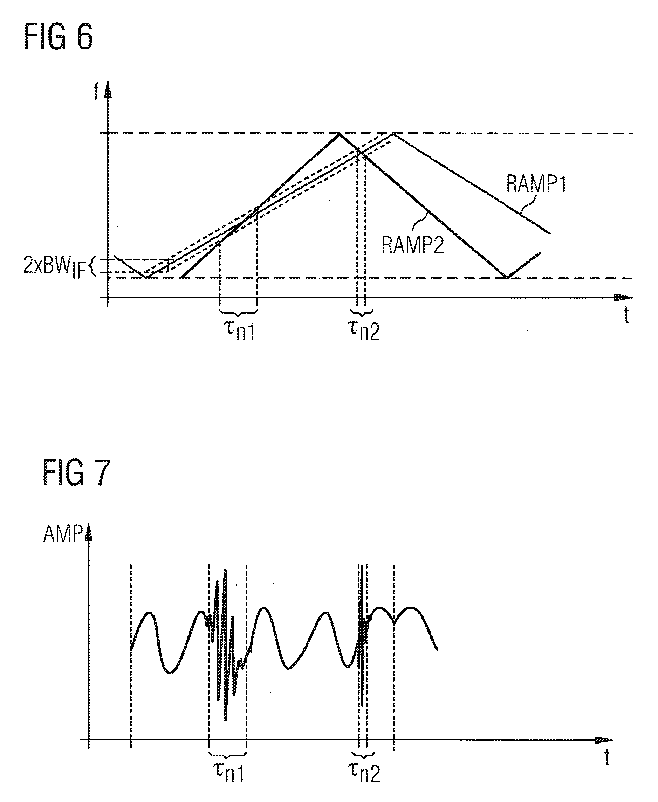

FIG 6 zeigt in einer Auftragung einer Frequenz f gegen eine Zeit t zwei Rampen RAMP1, RAMP 2 sich störender FMCW-Radare mit unterschiedlicher Rampenform (unterschiedlichem sog. Timing). Dabei kommt es in zwei unterschiedlich langen Zeitbereichen $\tau_{n1}$ und $\tau_{n2}$ zu Überschneidungen.

FIG 7 zeigt in einer Auftragung einer Amplitude AMP gegen eine Zeit t das sich bei einem der sich störenden FMCW-Radare von FIG 6 ergebende Sensorsignal. In den zwei Überschneidungszeitbereichen $\tau_{n1}$ und $\tau_{n2}$ wird das Amplitudensignal AMP erheblich gestört.

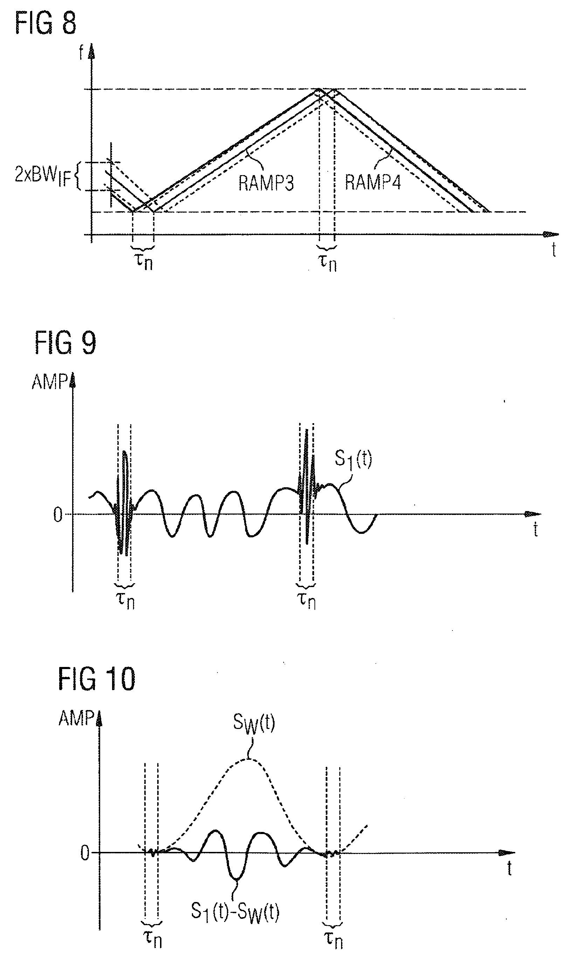

FIG 8 zeigt in einer Auftragung einer Frequenz f gegen eine Zeit t zwei Rampen RAMP3, RAMP 4 sich störender FMCW-Radare mit gleicher, aber versetzter Rampenform (gleiches Timing) mit einer Kreuzung der Rampen RAMP3, RAMP 4 am Rampenende bzw. Rampenanfang. Dabei kommt es in zwei gleich langen Zeitbereichen $\tau_{n31}$ zu Überschneidungen.

FIG 9 zeigt in einer Auftragung einer Amplitude AMP gegen eine Zeit t das sich bei einem der sich störenden FMCW-Radare von FIG 8 ergebende Sensorsignal $s_1(t)$. In den zwei Überschneidungszeitbereichen $\tau_{n3}$ ist das Amplitudensignal AMP erheblich gestört.

FIG 10 zeigt in einer Auftragung einer Amplitude AMP gegen eine Zeit t eine Ausblendung einer Überkreuzung der Rampen RAMP3, RAMP4 aus FIG 8 durch Subtraktion einer Wichtungsfunktion bzw. einem Wichtungssignal $s_w(t)$ vom Sensorsignal $s_1(t)$ aus FIG 9. Das Wichtungssignal $s_w(t)$ unterdrückt insbesondere das Sensorsignal $s_1(t)$ in den Überschneidungszeitbereichen $\tau_{n3}$ (Hann- bzw. Hanning-Fenster).

Selbstverständlich ist die vorliegende Erfindung nicht auf die oben beschriebenen Ausführungsformen beschränkt. So können mehrere der beschriebenen Maßnahmen und Anordnungen mit einander kombiniert werden. Auch sind Änderungen und Alternativen umfasst, welche zwar nicht explizit aufgeführt sind, sich aber dem Fachmann beim Lesen erschließen.

Bisher ist das Messen bei Anwesenheit weiterer Radarsensoren, die in das betrachtete System stark einstrahlen nicht bzw. nur mit deutlich reduzierter Empfindlichkeit möglich. In Systemen, die aus mehreren Radarsensoren bestehen, blenden sich zudem häufig gleichartige Sensoren, also solche Sensoren, deren Rampen mit geringer Toleranz zeitlich gleichartig verlaufen; dann tritt eine Störung über viele Messungen hinweg praktisch zu immer dem gleichen Zeitpunkt innerhalb der Messung auf. Bei völliger Synchronisation zweier Sensoren laufen die Rampen praktisch parallel, die Sensoren stören sich in diesem Fall während der gesamten Messung.

Wenn der Zeitpunkt der Überschneidung nicht festgestellt werden kann, ist es unmöglich, den gestörten Bereich des Messsignals zu verändern und damit ist die gesamte Messung ungültig. Laufen die Sensoren dagegen mit einem kontrollierten Versatz zueinander, ist der Zeitpunkt der Störung einerseits bekannt, zum anderen ist er im Rahmen der Präzision der Rampensteuerung immer wieder zum gleichen Zeitpunkt innerhalb der Messungen. Da die Sensoren üblicherweise nicht miteinander kommunizieren können, ist eine kontrollierte Synchronisation nicht zu erreichen ist.

Die Erkennung und / oder Unterdrückung des Störsignals beruht unter einem Gesichtpunkt darauf, die Rampen von FMCW-Radaren so miteinander zu synchronisieren, dass sie sich nicht stören.

Dies kann beispielsweise wie folgt geschehen:

In einem Fall erfolgt die Störung über die Amplitude. Denn leuchten sich zwei Sensoren direkt an, besitzt das resultierende ZF-Störsignal eine deutlich höhere Amplitude als das Nutzsignal. Falls gewünscht, kann vorteilhafterweise durch eine zusätzliche Hochpassfilterung / Differenziation eine deutlichere Unterscheidung des Störsignals vom Nutzsignal erreicht werden. Das Störsignal reicht im Gegensatz zum Nutzsignal prinzipbedingt immer bis an die Bandgrenze des ZF-Filters heranreicht.

Alternativ oder zusätzlich erhält man den Zeitpunkt der Überkreuzung der Rampen über das zeitlich aufgelöste Spektrum des ZF-Signals. Dabei wird das Zeitsignal beispielsweise Stück für Stück spektral untersucht und ein kurzer breitbandiger Signalabschnitt als Überkreuzung identifiziert. Ist der Zeitpunkt der Störung bekannt, kann das ZF-Signal "entstört" werden. Dazu bieten sich vorteilhafterweise folgende Verfahren an:

Arbeiten die Sensoren in einem Frequenzband, welches schmaler ist als das Gesamtfrequenzband, kommt ein Frequenzversatz der einzelnen Sensoren relativ zueinander in Frage, um die einzelnen Sensoren zu entstören. Voraussetzung ist, dass das Frequenzband so breit ist, das alle Bänder der beteiligten Sensoren nebeneinander passen. Dieser Fall ist oft nicht gegeben.

Alternativ kann der Zeitbereich des ZF-Signals, in dem die Störung vorliegt, "dunkelgetastet" werden. Dabei werden im Wesentlichen die Messpunkte der Störung zu Null gesetzt. Dadurch verliert man allerdings effektiv an Bandbreite, u.U. beträchtlich, weil das nutzbare Zeitsignal kürzer wird.

Alternativ kann das ZF-Signal auch niederfrequent interpoliert werden.

Vorteilhafterweise wird zum Ausblenden eine Wichtungsfunktion verwendet, wodurch die Beeinträchtigung des Frequenzspektrums durch den Ausblendbereich vermindert wird.

Wenn der zeitliche Versatz der beiden sich störenden Rampen aus dem Zeitpunkt des Störsignals im Zeitbereich detektiert wurde, kann eine Synchronisation oder gewollte Nichtsynchronität der beiden Radarsysteme erreicht werden Der Startzeitpunkt der Rampen kann dazu z. B. so verschoben werden, dass stets ein ausreichender großer Frequenzversatz besteht, so dass das Störsignal deutlich außerhalb der Bandbreite des ZF-Filters liegt, aber gleichzeitig möglichst wenig Nutzsignal verloren geht. Besonders vorteilhaft wird der Kreuzungspunkt an den Anfang oder das Ende der Frequenzrampe gelegt. Das Messsignal wird vorteilhafterweise mit einer Fensterfunktion gewichtet, die die Signalanteile an den Rändern der Messung merklich unterdrückt. In diesem Fall, wird die Amplitude der Störung durch die Fensterfunktion ebenfalls stark abgedämpft.

Es ist auch eine Kombination der Verfahren möglich. In einer Ausgestaltung wird die Störung z. B. an den Randbereich verschoben und zusätzlich im Zeitbereich ausgeblendet.

Die vorgeschlagenen Verfahren setzen voraus, dass die Sensoren sich "miteinander absprechen", damit geregelt werden kann, welcher Sensor den Startzeitpunkt der Rampe in welcher Richtung verschiebt

Diese Kommunikation kann per Funk oder Kabel erfolgen. Alternativ kann ein Sensor als "Master", einer oder mehrere andere Sensoren können als "Slave" definiert werden. In diesem Fall detektiert nur ein Slave die Störung und verschiebt seinen Startzeitpunkt gemäß einem vorgegebenen Entstörziel.

Sollen sich zwei oder mehr Sensoren völlig ohne Konfiguration und Kommunikation arrangieren, können beispielsweise zufällige Verfahren angewandt werden. Dabei wird der Zeitpunkt des Rampenstarts in beiden Sensoren in vorgegeben Grenzen zufällig verschoben. Dabei sind unter anderem folgende Vorgehensweisen denkbar, die anhand von zwei CW-Sensoren beispielhaft ausgeführt werden:

- Das Vorzeichen des Zeitoffsets je Sensor ist zufällig: Beide Sensoren verschieben ihren Rampenstart um die Zeitspanne ±t, wobei das Vorzeichen zufällig ist. Wenn beide Sensoren in die gleiche Richtung springen, bleibt der Zeitpunkt der Störung relativ gesehen ortsfest. Wenn die Sensoren gegenläufig springen, wird das Vorzeichen beibehalten und die Rampe verschoben, bis das vorgegebene Ziel erreicht ist.

- Der Betrag des Zeitoffsets je Sensor ist zufällig: Beide Sensoren verschieben die Rampe um eine zufällige Zeit t1 und t2 in die gleiche Richtung. Bewegen sich die Rampen relativ zueinander in die richtige Richtung, werden die Rampen solange verschoben, bis das vorgegebene Ziel erreicht ist.

- Die Zahl der Frequenzrampen bis zur Synchronisierung ist zufällig: Jeder Sensor synchronisiert erst nach einer zufälligen Anzahl von sich störenden Rampen. Damit wird mit einer hohen Wahrscheinlichkeit erreicht, dass nicht zwei oder mehrere Sensoren zum gleichen Zeitpunkt die Synchronisation durchführen. Wird die Synchronisation mit diesem Verfahren also nur an einem Sensor durchgeführt, so erkennen die weiteren Sensoren in den darauffolgenden Rampen die bereits durchgeführte Synchronisation und verzichten daraufhin auf eigene Synchronisationsschritte. Die Synchronisation wird dabei vorzugsweise derart durchgeführt, dass der benötigte Zeitversatz aus der zeitlichen Position der Störung im Messsignal bestimmt wird und durch Einbringen eines entsprechenden Zeitversatzes in einem Schritt die gewünschte zeitliche Abfolge (Synchronität) erreicht wird. Damit kann ohne weitere Kommunikation der Sensoren ein System aus mehreren Sensoren synchronisiert und synchron gehalten werden. Damit jeder Sensor die Synchronisierung prüfen kann, ist es besonders vorteilhaft, wenn sich die Sensoren beispielsweise nur beim Heraufstimmen der Frequenz synchronisieren dürfen. Dann bleibt stets der Herabstimmvorgang, um die Synchronität zu überprüfen (oder umgekehrt).

- Das Durchstimmen einer Rampe an sich ist zufällig: Die Sensoren setzen zufällig mit ihrer Rampe aus. In diesem Fall wird eine Überkreuzung der Rampen dadurch vermieden, dass ein Sensor mit der Frequenz am Rand des Nutzbandes verweilt, bis die Dauer einer oder mehrerer Rampen verstrichen ist.

Es sind auch Kombinationen der genannten Vorgehensweisen möglich. Vorzugsweise kommen übliche Methoden der Wahrscheinlichkeitsrechnung und der Systemoptimierung zur Anwendung.

Grundsätzlich funktionieren diese Verfahren mit zwei oder mehr Sensoren.
Wird hingegen die Frequenz der Sensoren relativ zueinander verschoben, können Verfahren des Zeitbereichs analog für den Frequenzbereich angewandt werden.
Ist ein Sensor ein FMCW-Radar, der andere ein CW-Dopplersensor, so wird dies durch zuvorgenannte Verfahren ebenfalls erkannt. Daher ist eine Entstörung von FMCW- und Nicht-FMCW-Dopplerradaren ebenfalls vom Erfindungsgedanken umfasst. Wird ein FMCW-Radar durch ein CW-Radar gestört, findet die Störung zu immer dem gleichen Zeitpunkt innerhalb der Rampe statt, und zwar unabhängig von jeder Rampenverschiebung. Lediglich eine Frequenzverschiebung der Rampe führt zu einer Zeitverschiebung der Störung. Folglich kommt zur Entstörung lediglich das Dunkeltasten in Frage. Durch Verwendung mehrerer Ausblendbereiche können auch Störungen durch mehr als zwei CW-Radargeräte eliminiert werden. Im Dopplersensor wird die Störung durch ein FMCW-Radar dadurch erkannt, dass die Störung regelmäßig auftritt. Als Methoden zur Unterdrückung der Störung kommen unter anderem das Dunkeltasten sowie das Mitteln, wie zuvor beschrieben, in Frage.

**Patentansprüche**

1.  Verfahren zum Nachführen eines FMCW-Hintergrundsignals eines FMCW-Radars, aufweisend die folgenden Schritte:

    - Aufnehmen eines FMCW-Radarsignals;
    - Bestimmen des wahrscheinlichsten FMCW-Radar-Hintergrundsignals aus einer Mehrzahl von zuvor gespeicherten FMCW-Radar-Hintergrundsignalen; und
    - Vergleichen des aufgenommenen FMCW-Radarsignals mit dem wahrscheinlichsten FMCW-Radar-Hintergrundsignal,

    **dadurch gekennzeichnet, dass**

    - falls das aufgenommene FMCW-Radarsignal weniger als um einen vorbestimmten Schwellwert vom wahrscheinlichsten FMCW-Radar-Hintergrundsignal abweicht, das aufgenommene FMCW-Radarsignal als FMCW-Radar-Hintergrundsignal abgespeichert wird, und
    - das aufgenommene FMCW-Radarsignal nur dann als FMCW-Radar-Hintergrundsignal gespeichert wird, wenn im Messsignal kein signifikantes Dopplersignal ermittelt wird.

2.  Verfahren zur Unterdrückung eines FMCW-Radar-Hintergrundsignals eines FMCW-Radars, welches nach einem Verfahren gemäß Anspruch 1 ermittelt wird, aufweisend die folgenden Schritte:

- Aufnehmen eines FMCW-Radarsignals; und
- Vergleichen des aufgenommenen FMCW-Radarsignals mit dem wahrscheinlichsten FMCW-Radar-Hintergrundsignal,

**dadurch gekennzeichnet, dass** falls das aufgenommene FMCW-Radarsignal mehr als um einen vorbestimmten Schwellwert vom wahrscheinlichsten FMCW-Radar-Hintergrundsignal abweicht das wahrscheinlichste FMCW-Radar-Hintergrundsignal vom aufgenommenen FMCW-Radarsignal abgezogen wird.

3. Verfahren nach einem der Ansprüche 1 oder 2, bei dem das wahrscheinlichste FMCW-Radar-Hintergrundsignals aus einer Mittelung mehrerer FMCW-Radar-Hintergrundsignale erzeugt wird.

## Claims

1. Method for adaptively correcting an FMCW background signal of an FMCW radar, the method comprising the following steps of:

- recording an FMCW radar signal,
- determining the most probable FMCW radar background signal from a plurality of previously stored FMCW radar background signals, and
- comparing the recorded FMCW radar signal with the most probable FMCW radar background signal,

**characterised in that**

- if the recorded FMCW radar signal differs from the most probable FMCW radar background signal by less than a predetermined threshold value, the recorded FMCW radar signal is stored as the FMCW radar background signal, and
- the recorded FMCW radar signal is stored as the FMCW radar background signal only if no significant Doppler signal is determined in the measurement signal.

2. Method for suppressing an FMCW radar background signal of an FMCW radar, which signal is determined by means of a method according to claim 1, the method comprising the following steps of:

- recording an FMCW radar signal, and
- comparing the recorded FMCW radar signal with the most probable FMCW radar background signal,

**characterised in that** if the recorded FMCW radar signal differs from the most probable FMCW radar background signal by more than a predetermined threshold value, the most probable FMCW radar background signal is subtracted from the recorded FMCW radar signal.

3. Method according to one of claims 1 or 2, wherein the most probable FMCW radar background signal is generated from an averaging of a plurality of FMCW radar background signals.

## Revendications

1. Procédé de poursuite d'un signal de fond FMCW d'un radar FMCW, comportant les étapes suivantes :

- enregistrement d'un signal de radar FMCW,
- détermination du signal de fond de radar FMCW le plus probable à partir d'une pluralité de signaux de fond de radar FMCW préalablement mis en mémoire et
- comparaison du signal de radar FMCW enregistré avec le signal de fond de radar FMCW le plus probable,

**caractérisé en ce que**

- si le signal de radar FMCW enregistré s'écarte du signal de fond de radar FMCW le plus probable de moins d'une valeur seuil prédéterminée, le signal de radar FMCW enregistré est stocké en tant que signal de fond de radar FMCW et
- le signal de radar FMCW enregistré n'est stocké en tant que signal de fond de radar FMCW que si aucun signal Doppler significatif n'est déterminé dans le signal de mesure.

2. Procédé de suppression d'un signal de fond de radar FMCW d'un radar FMCW qui a été déterminé selon un procédé selon la revendication 1, comportant les étapes suivantes :

- enregistrement d'un signal de radar FMCW et
- comparaison du signal de radar FMCW enregistré avec le signal de fond de radar FMCW le plus probable,

**caractérisé en ce que**, si le signal de radar FMCW enregistré s'écarte du signal de fond de radar FMCW le plus probable de plus d'une valeur seuil prédéterminée, le signal de fond de radar FMCW le plus probable est soustrait du signal de radar FMCW enregistré.

3. Procédé selon l'une des revendications 1 ou 2, dans lequel le signal de fond de radar FMCW le plus probable est généré à partir d'un calcul de la moyenne de plusieurs signaux de fond de radar FMCW.

FIG 1

FIG 2

FIG 3

FIG 4A  SIG

SIG-B+SIG-T

f

FIG 4B  SIG

SIG-B

f

FIG 4C  SIG

SIG-T

f

FIG 5A

τ

| P1 | P2 | ~P1 | P3 | ~P3 | ~P1 | P4 | P5 | ~P1 | ~P1 | P6 | ← T |

FIG 5B

| P1 | ~P1 | ~P1 | ~P1/P2 | ~P2 | ~P2 | P2 | ~P2 | P3 | P4 | ~P2 | ← T |

FIG 5C

τ

| P1 | ~P1 | ~P1 | P2 | ~P2 | ~P2 | ~P2 | ~P2 | ~P2 | ~P2 | ~P2 | ← T |

Δτ

P1 → P2

## FIG 6

## FIG 7

FIG 8

FIG 9

FIG 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2003020647 A1
- EP 0816872 A
- US 2811715 A